(19) **Europäisches Patentamt / European Patent Office / Office européen des brevets**

(11) **EP 2 215 766 B1**

(12) # EUROPÄISCHE PATENTSCHRIFT

(45) Veröffentlichungstag und Bekanntmachung des Hinweises auf die Patenterteilung:
**23.03.2011 Patentblatt 2011/12**

(21) Anmeldenummer: **08801633.2**

(22) Anmeldetag: **20.08.2008**

(51) Int Cl.:
**H04L 7/033** (2006.01)   **H03L 7/099** (2006.01)

(86) Internationale Anmeldenummer:
**PCT/EP2008/006852**

(87) Internationale Veröffentlichungsnummer:
**WO 2009/039924 (02.04.2009 Gazette 2009/14)**

(54) **VERFAHREN UND VORRICHTUNG ZUR TAKTRÜCKGEWINNUNG**

METHOD AND DEVICE FOR CLOCK RECOVERY

PROCÉDÉ ET DISPOSITIF DE RÉCUPÉRATION D'HORLOGE

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **21.09.2007 DE 102007045085**
**29.02.2008 DE 102008011845**

(43) Veröffentlichungstag der Anmeldung:
**11.08.2010 Patentblatt 2010/32**

(73) Patentinhaber: **Rohde & Schwarz GmbH & Co. KG**
**81671 München (DE)**

(72) Erfinder:
• **VILLARINO-VILLA, Rubén**
**80333 München (DE)**
• **FREIDHOF, Markus**
**85614 Kirchseeon (DE)**
• **KUHWALD, Thomas**
**83623 Dietramszell (DE)**

(74) Vertreter: **Körfer, Thomas et al**
**Mitscherlich & Partner**
**Patent- und Rechtsanwälte**
**Postfach 33 06 09**
**80066 München (DE)**

(56) Entgegenhaltungen:
**EP-A- 0 312 671    EP-A- 0 912 010**
**GB-A- 2 359 223    US-A- 4 771 250**
**US-A1- 2004 096 025**

• PARHI K K ET AL: "PIPELINE INTERLEAVING AND PARALLELISM IN RECURSIVE DIGITAL FILTERS-PART I: PIPELINING USING SCATTERED LOOK-AHEAD AND DECOMPOSITION" IEEE TRANSACTIONS ON ACOUSTICS, SPEECH AND SIGNAL PROCESSING, IEEE INC. NEW YORK, USA, Bd. 37, Nr. 7, 1. Juli 1989 (1989-07-01), Seiten 1099-1117, XP000037327 ISSN: 0096-3518 in der Anmeldung erwähnt
• PARHI K K ET AL: "PIPELINE INTERLEAVING AND PARALLELISM IN RECURSIVE DIGITAL FILTERS-PART II: PIPELINED INCREMENTAL BLOCK FILTERING" IEEE TRANSACTIONS ON ACOUSTICS, SPEECH AND SIGNAL PROCESSING, IEEE INC. NEW YORK, USA, Bd. 37, Nr. 7, 1. Juli 1989 (1989-07-01), Seiten 1118-1134, XP000037328 ISSN: 0096-3518 in der Anmeldung erwähnt

EP 2 215 766 B1

**Beschreibung**

Die Erfindung betrifft ein Verfahren zur Taktrückgewinnung gemäß dem Oberbegriff des unabhängigen Patentanspruchs 1 und eine zugehörige Vorrichtung.

TECHNISCHER HINTERGRUND UND STAND DER TECHNIK

In der digitalen Übertragungstechnik werden manche binären Datenströme, insbesondere serielle Datenströme mit hoher Bitrate, ohne begleitendes Taktsignal gesendet. Ziel der Taktrückgewinnung (Englisch: Clock Data Recovery CDR) ist, aus dem empfangenen Datenstrom die Frequenz und Phase des unterliegenden Sendetakts zu ermitteln.

In einem üblichen Empfänger dient das zurück gewonnene Clocksignal zur Dekodierung der gesendeten Bitfolge durch Abtastung der empfangenen Signalpulse genau in der Mitte zur Maximierung des Signal-Stör-Verhältnisses. In der Signalanalyse verwendet man das zurück gewonnene Clocksignal zur Beurteilung der Signalqualität typischerweise anhand so genannter Augendiagramme (Englisch: eye diagram) und mathematischer Werkzeuge zur Jitteranalyse.

Der Sendetakt wird oft mittels einer PLL (Englisch: Phase-Locked Loop), eines phasengekoppelten Regelkreises, ermittelt. Zur Signalqualitätsanalyse schreiben verschiedene Standards einen normierten Empfänger in der Form von PLL-Eigenschaften vor. Das zurück gewonnene Clocksignal bestimmt in diesem Zusammenhang definitionsgemäß den idealen Bitbeginnzeitpunkt. Die Auswertung der Abweichungen zwischen den Nulldurchgängen im empfangenen Datenstrom und im Clocksignal bildet die Grundlage der Jitteranalyse.

Zur Signal- bzw. Jitteranalyse wird der Sendetakt grundsätzlich auf zwei verschiedene Weisen zurück gewonnen:

- Die PLL wird mit Bausteinen in Hardware realisiert. Der Anwender speist den zeitkontinuierlichen Datenstrom in die PLL ein und erhält ein zeitkontinuierliches Clocksignal und den um die Verarbeitungslatenz verzögerten Datenstrom zurück. Datenstrom und Clocksignal sind miteinander synchronisiert. Das Verfahren arbeitet online in Echtzeit, der Datenstrom wird ständig beobachtet.
- Die PLL wird in Software mit einer Rechenvorschrift nachgebildet. Ein Messgerät nimmt einen Abschnitt des Datenstroms auf und wendet den Taktrückgewinnungsalgorithmus darauf an. Daraus wird das Clocksignal für den aufgenommenen Datenabschnitt zurück gewonnen. Das Verfahren arbeitet in der Regel offline, denn die Verarbeitungszeit des Algorithmus ist höher als die zeitliche Dauer des aufgenommenen Datenabschnitts.

Im Stand der Technik bekannte Hardware-PLLs können in drei Kategorien gegliedert werden: Lineare PLLs, digitale PLLs und volldigitale PLLs (Englisch: All-Digital PLL). Alle drei PLL-Typen verarbeiten und erzeugen analoge, zeitkontinuierliche Signale, wobei die digitale und volldigitale PLLs an die Verarbeitung von binären seriellen Datenströmen angepasst sind.

Mit Software-PLL bezeichnet man allgemein eine Rechenvorschrift, welche die Funktionsweise einer Hardware-PLL nachbildet. Ein Ansatz besteht darin, die Arbeitsweise der analogen Bausteine mathematisch zu beschreiben und damit eine hoch abgetastete Version des empfangenen Datenstroms zu verarbeiten. Ein zweiter Ansatz basiert auf der Beobachtung, dass nur die Nulldurchgänge im Datenstrom die relevante Information für die Taktrückgewinnung enthalten. In diesem Fall ermittelt man zunächst die Lage der Nulldurchgänge durch Interpolation des gespeicherten Datenabschnitts und berechnet anschließend daraus die Nulldurchgänge des ClockSignals.

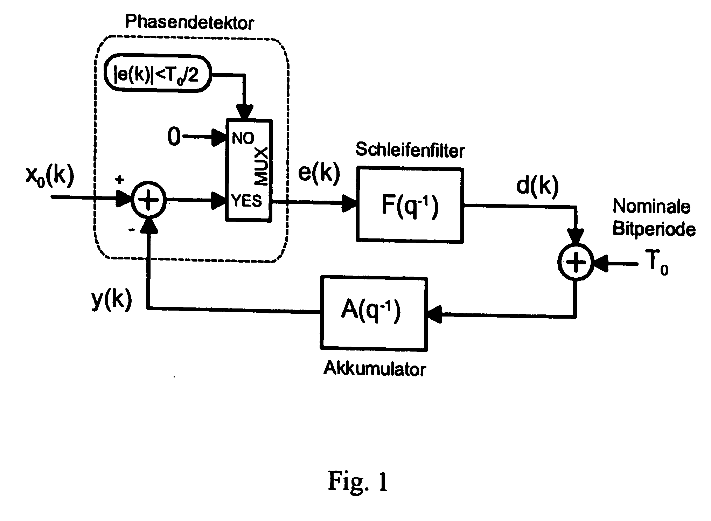

**Figur 1** zeigt die vereinfachte Struktur einer Software-PLL nach dem letzten Ansatz gemäß dem Stand der Technik. Das Eingangssignal $x_0(k)$ ist eine Liste mit der zeitlichen Position der Nulldurchgänge im Datenstrom, im Folgenden auch Datenflanken genannt. Mit $y(k)$ werden die berechneten Clockflanken bezeichnet. Die PLL generiert nur eine Clockflanke pro Bitperiode. Stellt man sich das zugrunde liegende, zeitkontinuierliche Clocksignal als eine Sinusschwingung vor, dann bezeichnet $y(k)$ die Zeitpunkte mit Phase gleich 0.

Die $x_0(k)$ sind chronologisch sortiert und werden sequenziell verarbeitet. Zunächst wird im Phasendetektor die Zeitdifferenz $e(k)$ zwischen Daten- und Clockflanken gebildet. Da kein Signaldurchgang stattfindet, wenn der Sender zwei oder mehr gleiche Bits nacheinander überträgt, ist die Datenflankenanzahl in der Regel kleiner als die Anzahl übertragener Bits. Ist der Zeitdifferenzbetrag größer als eine halbe Bitperiode $T_0$, dann schließt man auf eine Flankenlücke zurück und setzt exemplarisch $e(k) = 0$, andernfalls leitet der Phasendetektor die Zeitdifferenz $e(k)$ unverändert weiter. Der Term $e(k)$ wird mit dem Schleifenfilter (Engl: loop filter) $F(q^{-1})$ gefiltert. $F(q^{-1})$ beschreibt eine Differenzengleichung als Funktion des Verzögerungsoperators $q^{-1}$, für den exemplarisch gilt: $2 \cdot q^{-1} \cdot e(k) = 2 \cdot e(k-1)$. Das resultierende $d(k)$ zusammen mit der Konstante $T_0$, welche die nominale Bitperiode des Datenstroms angibt, liefert eine Schätzung der momentanen Bitperiode des Datenstroms. Der Akkumulator $A(q^{-1})$ ermittelt die Lage der nächsten Clockflanke, indem die momentane Bitperiodenschätzung zur letzten Clockflanke hinzuaddiert wird. Algorithmisch lässt sich die grundlegende Funktionsweise wie folgt beschreiben:

$$\text{Phasen- bzw. Timing-Fehler:} \qquad e(k) = x_0(k) - y(k)$$

$$\text{Gefilterter Fehler:} \qquad d(k) = F(q^{-1}) \cdot e(k)$$

$$\text{Momentane Bitperiodenschätzung:} \quad T_b(k) = T_0 + d(k)$$

$$\text{Nächste Clockflanke:} \qquad y(k+1) = q \cdot A(q^{-1}) \cdot T_b(k)$$

Durch gezielte Wahl der Koeffizienten von $F(q^{-1})$ und $A(q^{-1})$ kann die obige Software-PLL, solange sie offline arbeitet, die theoretische PLL-Übertragungsfunktion sehr gut approximieren. Bei einer in Echtzeit arbeitenden Realisierung soll man beachten, dass jeder der obigen Verarbeitungsschritte eine gewisse Verarbeitungszeit erfordert. Die gesamte realisierungsbedingte Verzögerung verfälscht die Übertragungsfunktion des Regelkreises und kann sogar die Stabilität gefährden. Als Faustregel ist eine echzeitfähige Software-PLL gemäß dem Stand der Technik nur zur Analyse von Datenströmen einsetzbar, deren Bitperiode größer als die Verarbeitungszeit zur Berechnung einer neuen Clockflanke ist.

Aus der EP 0 912 010 A1 ist ein Abtastregelkreis für eine Empfangsschaltung von digital übertragbaren Signalen bekannt. Dieser ist zur optimalen Abtastung der einzelnen Symbole mit einem Abweichungsdetektor verbunden, der die jeweiligen Zeitabweichungswerte bestimmt. Das Regelverhalten des Abtastregelkreises wird dadurch verbessert, dass eine Bewertungseinrichtung aus Signalen der Empfangsschaltung einen Zuverlässigkeitswert bestimmt und den Abtastregelkreis in Abhängigkeit von dem Zuverlässigkeitswert steuert.

AUFGABE DER ERFINDUNG

Aufgabe der vorliegenden Erfindung ist, ein Verfahren und eine Vorrichtung zur Taktrückgewinnung bereit zu stellen, die die Clockflankenpositionen durch die parallele Verarbeitung mehrerer Datenflanken ermittelt. Die parallele Verarbeitung ermöglicht einen höheren Durchsatz als bei herkömmlichen Software-PLLs. Das Verfahren und die Vorrichtung approximieren die theoretische PLL-Übertragungsfunktion, wobei die Stabilität des Regelkreises immer gewährleistet ist.

KURZE ZUSAMMENFASSUNG DER ERFINDUNG

Diese Aufgabe wird gelöst durch ein Verfahren und eine Vorrichtung zur Taktrückgewinnung gemäß den unabhängigen Patentansprüchen. Vorteilhafte Ausführungsformen sind in den abhängigen Patentansprüchen definiert.

Die Schritte des Verfahrens zur Taktrückgewinnung gemäß der Erfindung sind:

- Abzug eines auf der nominalen Bitperiode $T_0$ basierenden Clocksignals (Nominal Clock). Das entspricht der Beseitigung eines linearen Trends aus den Datenflanken.
- Filterung der trendbereinigten Datenflanken zur Rückgewinnung der entsprechend trendbereinigten Clockflanken.
- Einfügen des Nominal Clocks zur Ermittlung der endgültigen Clockflankenpositionen.

Mit anderen Worten wird der Regelkreis aus **Figur 1** so umgeformt, dass der PLL-Kern nur aus dem Schleifenfilter $F(q^{-1})$, dem Akkumulator $A(q^{-1})$ und dem Addierer zur Ermittlung des Phasenfehlers $e(k)$ besteht. Eine Hilfskonstruktion außerhalb des Regelkreises erkennt die Flankenlücken und ordnet dementsprechend Clock- und Datenflanken zu. Der Beitrag der nominalen Bitperiode $T_0$ wird durch zusätzliche Hilfskonstruktionen ersetzt, die einen linearen Trend vor und nach dem Hauptregelkreis, im Folgenden auch PLL-Kern genannt, jeweils abziehen und wieder hinzufügen. Der verbleibende PLL-Kern ist durch eine herkömmliche lineare Differenzengleichung gegeben.

Alle Funktionsblöcke und Verarbeitungsschritte können eine Vielzahl von Flanken parallel verarbeiten. Vorteilhafte Ausführungsformen werden im Folgenden skizziert.

KURZE BESCHREIBUNG DER ZEICHUNGEN

In der Zeichnung zeigen

Fig. 1   ein Blockschaltbild einer bisher üblichen, datenflankenverarbeitenden Software-PLL;

Fig. 2   Blockschaltbilder einer Software-PLL gemäß zwei Ausführungsformen der Erfindung;

Fig.3   die Paarung von Daten- und Clockflanken (Flankenzuordnung);

Fig. 4   den Phasenoffset bei der Flankenzuordnung;

Fig. 5   die Bestimmung der effektiven Clockflankenanzahl;

Fig. 6   zwei Methoden zur Flankenzuordnung;

Fig. 7   ein Blockschaltbild eines Gesamtsystems zur Taktrückgewinnung gemäß einer Ausführungsform der Erfindung;

Fig. 8   ein weiteres Blockschaltbild eines Gesamtsystems zur Taktrückgewinnung gemäß einer zweiten Ausführungsform der Erfindung.

DETAILLIERTE BESCHREIBUNG DER ERFINDUNG

Die Erfindung hat ihren Ursprung in der Umformung des klassischen Blockschaltbilds einer Software-PLL.

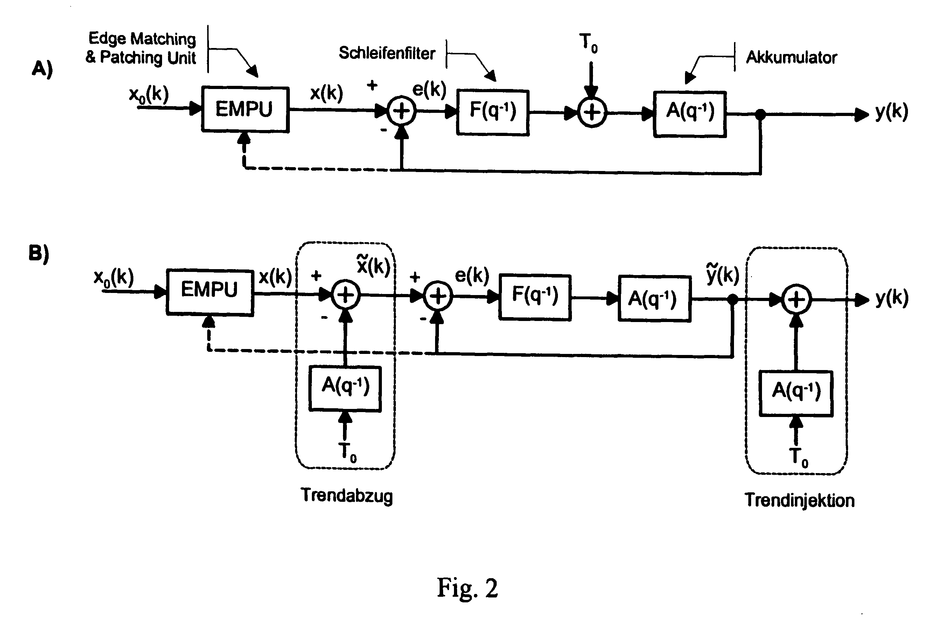

**Figur 2** zeigt in Blockschaltbild A eine erste Umformung des Blockschaltbilds aus **Figur 1.** Die im Phasendetektor durchgeführte Zuordnung der Clock- und Datenflanken wird außerhalb des Regelkreises in den Block EMPU (Edge Matching and Patching Unit) verlagert. Aus der rohen Datenflankefolge $x_0(k)$, welche in der Regel mehrere Flankenlücken aufweist, liefert die EMPU eine interpolierte, lückenlose Datenflankenfolge $x(k)$. Die gestrichelte Linie weist darauf hin, dass die EMPU mit dem Hauptregelkreis beispielsweise über die zurück gewonnenen Clockflanken $y(k)$ gekoppelt ist. Mögliche Ausführungsformen des Blocks werden später in den abhängigen Patentansprüchen erläutert.

Das Blockschaltbild B aus **Figur 2** stellt die zweite, auf Blockschaltbild A aufbauende Umformung der Struktur einer Software-PLL gemäß der Erfindung. Der Beitrag der nominalen Bitperiode $T_0$, welche die PLL bei unterdrücktem Schleifenfilterausgang mit der nominalen Bitperiode laufen lässt und in einer zeitkontinuierlichen PLL die Nominalfrequenz des VCOs (Englisch: Voltage Controlled Oscillator) entspricht, wird im Blockschaltbild B in Figur 2 aus der Schleife beseitigt und durch eine Vor- und eine Nachverarbeitungsstufe ersetzt.

Das Schleifenfilter $F(q^{-1})$ und der Akkumulator $A(q^{-1})$ definieren herkömmliche lineare Differenzengleichungen als Funktion des Verzögerungsoperators $q^{-1}$. Beispielsweise beschreibt

$$a(k) = G(q^{-1})b(k) \quad \text{mit} \quad G(q^{-1}) = \frac{1 + g_2 \cdot q^{-1}}{1 - g_1 \cdot q^{-1}}$$

die Differenzengleichung

$$a(k) - g_1 \cdot a(k-1) = b(k) + g_2 \cdot b(k-1) \, .$$

Gemäß Blockschaltbild A in Figur 2 gilt

$$y(k) = A(q^{-1}) \cdot \left( F(q^{-1}) \cdot \left( x(k) - y(k) \right) + T_0 \right). \qquad (1)$$

Man definiere

$$\tilde{x}(k) = x(k) - A(q^{-1}) \cdot T_0 \, , \qquad \tilde{y}(k) = y(k) - A(q^{-1}) \cdot T_0 \, . (2)$$

Hierbei beobachte man, dass der Term $t(k) = A(q^{-1}) \cdot T_0$ das Akkumulieren bzw. Integrieren eines konstanten Signals mit wachsendem Flankenindex k beschreibt und funktionell eine Gerade der Steigung $T_0$ definiert.

Aus Gleichungen (1) und (2) ergibt sich

$$y(k) = \; A(q^{-1}) \cdot \Big( F(q^{-1}) \cdot \big( x(k) - y(k) \big) \Big) + A(q^{-1}) \cdot T_0$$
$$= \; A(q^{-1}) \cdot \Big( F(q^{-1}) \cdot \big( x(k) - y(k) + A(q^{-1}) \cdot T_0 - A(q^{-1}) \cdot T_0 \big) \Big) + A(q^{-1}) \cdot T_0 \quad . \quad (3)$$

Daraus folgt schließlich

$$\widetilde{y}(k) = A(q^{-1}) \cdot F(q^{-1}) \cdot \big( \widetilde{x}(k) - \widetilde{y}(k) \big) \qquad (4)$$

Gleichung (4) entspricht der Regelschleife in Blockschaltbild B in Figur 2, wobei Gleichung (2) die Vorverarbeitungsstufe ('Trendabzug') und die Nachverarbeitungsstufe ('Trendinjektion') beschreibt.

Konsequenz der Struktur in Blockschaltbild B ist, dass sich die Übertragungsfunktion der Regelschleife als lineares, rationales Filter bzw. lineare Differenzengleichung

$$H(q^{-1}) = \frac{F(q^{-1}) \cdot A(q^{-1})}{1 + F(q^{-1}) \cdot A(q^{-1})} = \frac{\sum_{n=0}^{N} b_n \cdot q^{-n}}{\sum_{m=0}^{M} a_m \cdot q^{-m}} \qquad (5)$$

ausdrücken lässt. Durch die Umwandlung in eine Differenzengleichung geht die ursprüngliche Struktur der Software-PLL aus Figur 1 größtenteils verloren, beispielsweise werden die Größen e(k) und d(k) nicht mehr explizit berechnet. Der Vorteil ist, dass Gleichung (5) mit aus der Literatur bekannten Verfahren wie etwa 'Clustered Look-Ahead' oder 'Scattered Look-Ahead' in Pipeline-Form realisierbar ist. Parallele Implementierungen rekursiver Filter werden insbesondere in den beiden Artikeln von K. Parhi und D. Messerschmitt ("Pipeline Interleaving and Parallelism in Recursive Digital Filters - Part I: Pipelining Using Scattered Look-Ahead and Decomposition" und "Pipeline Interleaving and Parallelism in Recursive Digital Filters - Part II: Pipelined Incremental Block Filtering", IEEE Transactions on Acoustics, Speech and Signal Processing, Vol. 37, No. 7, Juli 1989, Seiten 1099 bis 1117 bzw. Seiten 1118 bis 1134) beschrieben, deren Inhalt im Wege der Bezugnahme vollumfänglich in diese Beschreibung aufgenommen wird. An dieser Stelle beschränkt der langsamste grundlegende Verarbeitungsschritt die maximal analysierbare Datenstrombitrate, typischerweise der Systemtakt und nicht die Gesamtverarbeitungszeit des Regelkreises wie in einer herkömmlichen Software-PLL.

Ein zusätzlicher Aufwand ergibt sich aufgrund der Vor- und Nachverarbeitungsstufen. Der Term $t(k) = A(q^{-1}) \cdot T_0$ aus Gleichung (2) beschreibt eine Gerade der konstanten Steigung $T_0$ über den Index k. Der Vorverarbeitungsblock zieht diesen linearen Trend von den ankommenden Datenflanken $x(k)$ ab und der Nachverarbeitungsblock addiert ihn wieder zum PLL-Ausgang.

Grundsätzlich stellen die Datenflankenpositionen des analysierten Datenstroms eine Gerade der Steigung $T_b$ über den Index k dar. Nach Abzug des linearen Trends bleibt ein Resttrend der Steigung $(T_b{-}T_0)$ übrig. Folglich wachsen die Terme $|\widetilde{x}(k)|$ und $|\widetilde{y}(k)|$ mit der Zeit uneingeschränkt, wenn die Datenstrombitperiode $T_b$ vom nominalen Wert $T_0$ abweicht. Damit $|\widetilde{x}(k)|$ und $|\widetilde{y}(k)|$ begrenzt bleiben, müssen beide Größen gelegentlich um einen bestimmten Offset zurückgesetzt werden. Dies kann durch gleichzeitige Erhöhung der Hilfsblöcke und Rücksetzung des Zustands der Hauptregelschleife, im Folgenden auch PLL-Kern genannt, um den gleichen Offsetwert erfolgen. Damit bleibt die Differenz $e(k) = \widetilde{x}(k){-}\widetilde{y}(k)$ erhalten.

Insbesondere kann die Implementierung aller Funktionsblöcke zur Steigerung der Arbeitsgeschwindigkeit parallel erfolgen. Darunter versteht man, dass mehrere aufeinander folgende Elemente der Datenflankenfolge $x_0(k)$ im gleichen Arbeitsschritt verarbeitet werden. Die resultierende Clockflankenfolge $y(k)$ ist theoretisch identisch zur sequenziellen Verarbeitung von $x_0(k)$ mit einer herkömmlichen Software-PLL nach dem Stand der Technik.

Der parallele Aufbau des Trendabzugsblocks und des Trendinjektionsblocks ist unkompliziert, denn der nominale Clock läuft mit der im Voraus bekannten nominalen Bitperiode $T_0$ weiter. Zur parallelen Realisierung des linearen Filters bzw. der linearen Differenzengleichung aus Gleichung (5) können beispielsweise aus der Literatur bekannte Verfahren zur rekursiven Blockfilterung (Englisch: pipelined block filtering) verwendet werden. Die parallele Flankenzuordnung in der EMPU nutzt eine Prädiktion der Clockflanken $y(k)$ als Grundlage. Funktionsweise und günstige Ausführungsformen der EMPU werden im Folgenden erläutert.

FUNKTIONSWEISE DER EMPU

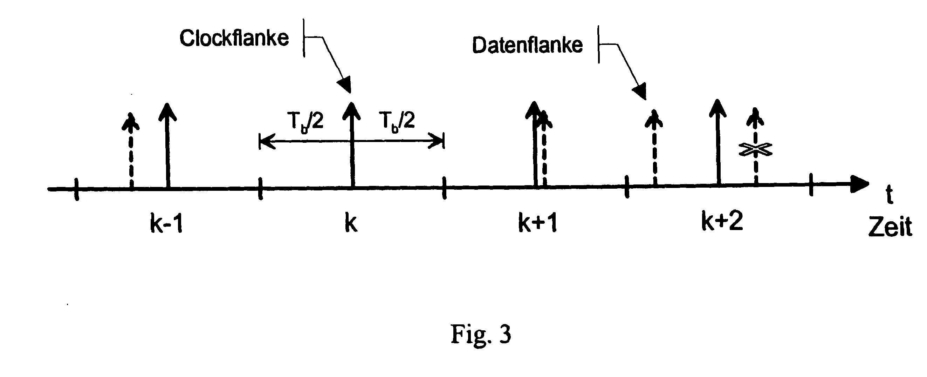

**Figur 3** zeigt an einem Beispiel das grundlegende Flankenzuordnungsproblem. Die Datenflanken $x_0(k)$ und Clockflanken $y(k)$ sind jeweils mit gestrichelten und durchgezogenen Pfeilen auf der Zeitachse eingetragen. Die zurück gewonnenen Clockflanken stellen definitionsgemäß die erwartete Lage der störungsfreien Datenflanken dar und werden für die Flankenzuweisung als Referenzpunkt genommen. Ausgehend von den Clockflanken wird die Zeitachse in aneinander liegende Intervalle aufgeteilt. Man stelle sich vereinfachend vor, dass jede Clockflanke in der Mitte eines Intervalls der Länge einer Bitperiode $T_b$ liegt.

Theoretisch können drei Fälle unterschieden werden:

1. Liegt eine einzige Datenflanke innerhalb eines bestimmten Intervalls, dann kann sie eindeutig zur entsprechenden Clockflanke zugeordnet werden (Indizes ‚k-1' und ‚k+1' in Figur 3).
2. Liegt keine Datenflanke in einem Intervall, kann eine sog. 'Flankenlücke' (Englisch: missing edge) vorliegen (Index ‚k'). Flankenlücken treten beim Übertragen der Folgen "...00..." oder "...11..." auf, denn zwischen den zwei Bits findet keinen Signalübergang statt. Flankenlücken können markiert und gesondert behandelt werden.
3. Mehrere Datenflanken im gleichen Intervall können auf Glitches im Signal, niedriges SNR oder eine noch nicht eingerastete PLL hindeuten. In diesem Fall kann eine Datenflanke beibehalten und die restlichen verworfen werden (Index ‚k+2'). Alternativ können alle Flanken verworfen werden, da im Grunde alle gleich falsch sind.

Herkömmliche Software- oder Hardware-PLLs arbeiten grundsätzlich sequenziell und ermitteln die Clockflanke $y(k+1)$ durch die Verarbeitung von früheren Daten- und Clockflanken bis zum Zeitindex k. Zur parallelen Flankenzuordnung des Datenflankenpaketes $[x(k+1), x(k+2), ..., x(k+N)]$ ist eine Prädiktion mehrerer Clockflanken erforderlich, d.h. die Terme $[y(k+1), y(k+2),...., y(k+N)]$ müssen aus den Informationen bis zum Zeitindex k geschätzt werden.

Zu diesem Zweck definiert die EMPU ein sekundäres Clocksignal, im Folgenden ‚Front Clock' genannt. Das Front Clock stellt eine Prädiktion der zurück gewonnenen Clockflanken $y(k)$ dar und wird zur Aufteilung der Zeitachse für die Flankenzuordnung genutzt. Der Front Clock ist mit dem PLL-Kern und folglich mit dem zurück gewonnenen Clockflanken $y(k)$ gekoppelt, wie die gestrichelte Linie in den Blockschaltbildern von Figur 2 andeutet.

In einer möglichen Ausführungsform läuft der Front Clock unmittelbar nach der Systeminitialisierung mit der nominalen Bitperiode $\hat{T}_b = T_0$ an. Erst nach $L$ Zeiteinheiten bzw. Systemtakten Verarbeitungslatenz beginnt der PLL-Kern die Datenflanken zu verarbeiten und die Clockflanken an den empfangenen Datenstrom durch Anpassung von $\hat{T}_b$ zu synchronisieren. Ab diesen Moment können Front Clock und der zurück gewonnene Clock, im Folgenden auch PLL-Clock genannt, miteinander gekoppelt arbeiten, denn der Front Clock kann beispielsweise $\hat{T}_b$ nutzen, um die Auslenkung des PLL-Clocks zu verfolgen.

Durch diese Vorgehensweise schätzt der Front Clock die künftigen Werte des PLL-Clocks nach dem Ansatz "der PLL-Clock wird für die nächsten L Systemtakte mit der nominalen Bitperiode fortlaufen". Bei Nichteinhaltung dieser Annahme tritt einen Phasenoffset zwischen beiden Clocks auf. Der Phasenoffset nach Einrasten der PLL auf einen Datenstrom mit konstanter Bitperiode $T_b$ lässt sich wie folgt approximieren

$$\varphi = \frac{T_b - T_0}{T_0} \cdot L \cdot (T_0 \cdot f_s)^{-1} \; [UI] \quad (\text{Unit Interval}) \quad (6)$$

wobei

$T_b$ : die Bitperiode des Datenstroms,
$T_0$ : die nominale Bitperiode,
$L$ : die Latenzzeit, gemessen in Systemtakten zwischen Flankenerkennung und Ausgang des linearen Filters bzw. PLL-Kerns,
$f_s$ : den Systemtakt des unterliegenden digitalen Systems (Bsp: Digitaler Signalprozessor) und
$(T_0 \cdot f_s)^{-1}$: die mittlere Anzahl von Bits in einem Systemtakt

bezeichnen.

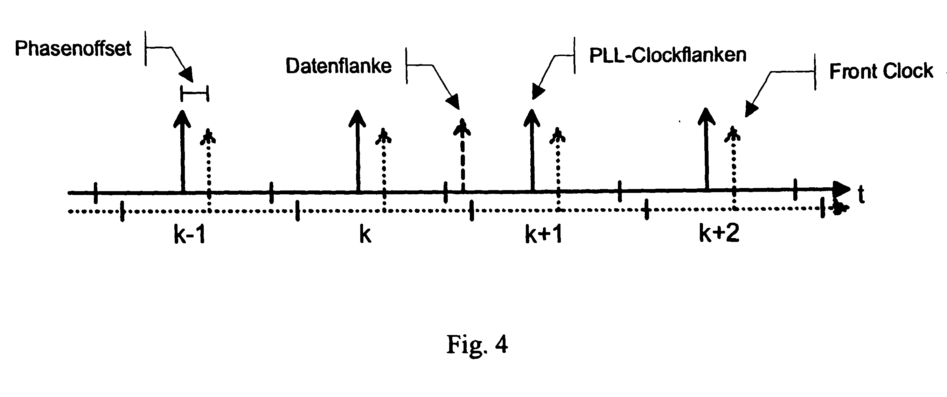

Der Phasenoffset bewirkt eine Verschiebung der Zeitintervalle in dem Fall, in welchem der PLL-Clock anstelle des Front Clocks zur Flankenzuordnung verwendet wurde. Bei dem in Figur 4 dargestellten Fall liegt die Datenflanke so ungünstig, dass die EMPU sie aufgrund des Phasenoffsets irrtümlich zum $k$-ten Intervall zuordnet. Ein zu großer Phasenoffset kann die Einrasteigenschaften und Jitterrobustheit der Taktrückgewinnung merklich beeinträchtigen.

Ein verbessertes Verhalten erhält man in der Regel, wenn man den Front Clock nach dem Ansatz "der PLL-Clock wird für die nächsten L Systemtakte mit der zuletzt geschätzten momentanen Bitperiode fortlaufen" bestimmt. Andere Prädiktionsansätze sind denkbar.

In einem online arbeitenden System wird der Datenstrom ständig beobachtet. Regelmäßig, wie beispielsweise jeden Systemtakt, werden der Taktrückgewinnung eine Menge neuer Datenflanken über eine externe Hilfsvorrichtung bereitgestellt. Ein Systemtakt definiert ein bestimmtes Fenster auf der Zeitachse. Vor diesem Hintergrund lässt sich die Funktionsweise der EMPU in zwei Unteraufgaben teilen. Zunächst werden mit Hilfe des Front Clocks die vom aktuellen Systemtakt bzw. aktuellen Zeitfenster gedeckten Clockflanken ermittelt. Anschließend werden die empfangenen Datenflanken mit den Clockflanken gepaart.

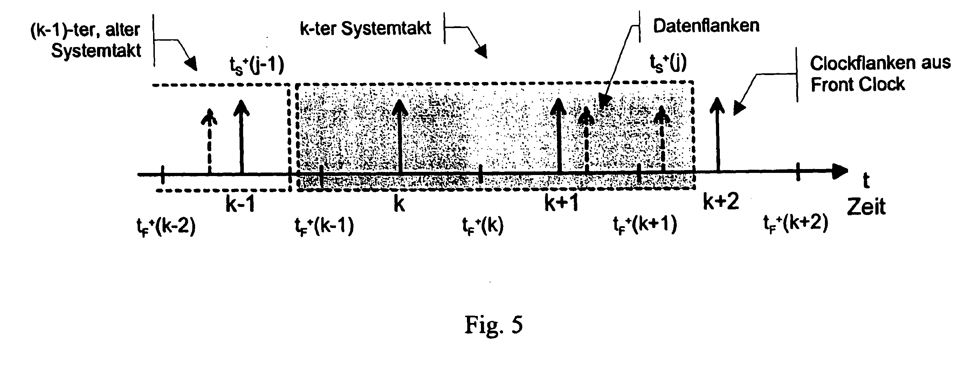

Das Beispiel in Figur 5 dient zur Erläuterung. Daten- und Clockflanken liegen jeweils als gestrichelte und durchgezogene Pfeile auf der Zeitachse. Das vom aktuellen Systemtakt definierte Zeitfenster ist mit grauem Hintergrund gekennzeichnet. Man beobachtet:

- Das $k$-te und ($k+1$)-te Intervall passen vollständig im Zeitfenster. Die eindeutige Zuordnung von Clock- und Datenflanken ist möglich.
- Der Teil vom ($k-1$)-ten Intervall, der noch nicht im ($j-1$)-ten Systemtakt beobachtet wurde, wird vom aktuellen Zeitfenster gedeckt. Nachdem man das ($k-1$)-te Intervall vollständig belichtet hat, ist eine eindeutige Flankenzuordnung auch möglich.
- Das ($k+2$)-te Intervall ist nur teilweise gedeckt und kann nicht zur Flankenzuordnung freigegeben werden. Die bereits im Intervall liegende Datenflanke wird aufbewahrt und im nächsten Systemtakt ausgewertet.

Der Front Clock gibt die Lage der Clockflanken $t_F(k)$ vor. Zur Bestimmung der vom aktuellen Zeitfenster gedeckten Zeitintervalle ist es hilfreich, die obere Grenze des k-ten Intervalls $t_F^+(k)$, welche aus den Clockflanken beispielsweise gemäß

$$t_F^+(k) = t_F(k) + T_0 / 2$$ abgeleitet wird, mit der oberen Grenzen des k-ten Systemtakts zu vergleichen. In Bezug auf Figur 5 gilt:

- $t_F^+(k-1)$ wurde bereits bei der Auswertung des ($k-1$)-ten Sample Packet berechnet und ist bekannt.

- $t_F^+(k-1)$, $t_F^+(k)$ und $t_F^+(k+1)$ sind alle kleiner als $t_S^+(j)$. Die entsprechenden Intervalle werden für die Flankenzuordnung freigegeben. Die Anzahl verarbeiteter Clockflanken ist drei.

- $t_F^+(k+2)$ ist größer als als $t_S^+(j)$. Sowohl $t_F^+(k+2)$ als auch die empfangene Datenflanke werden bis zum nächsten Systemtakt aufbewahrt.

Zusammenfassend wird die effektive Anzahl von Clockflanken im j-ten Systemtakt dadurch bestimmt, wie viele $t_F^+(k)$ zwischen die Zeitpunkte $t_S^+(j-1)$ und $t_S^+(j)$ passen.

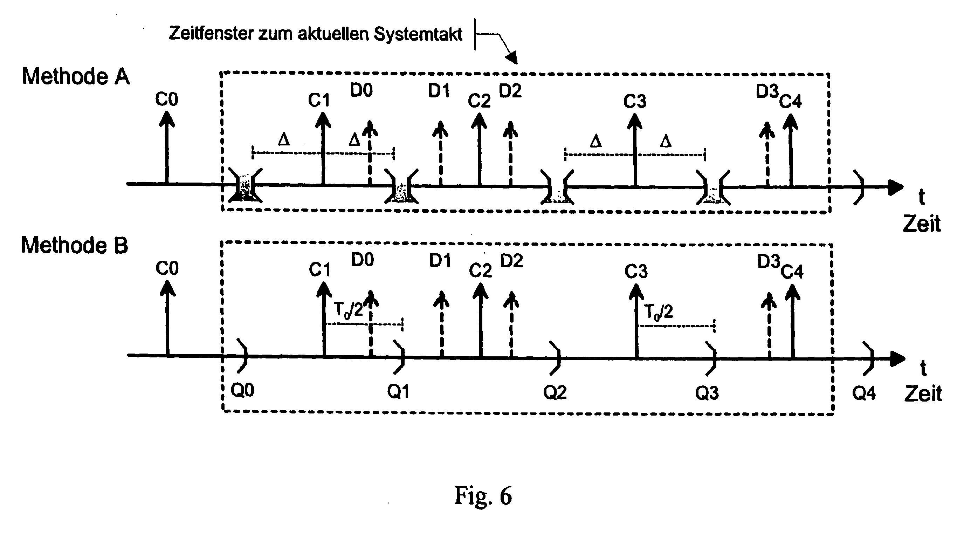

Nach Bestimmung der relevanten Zeitintervalle des aktuellen Zeitfensters findet die Zuordnung der Daten- und Clockflanken statt. **Figur 6** stellt zwei mögliche Verfahren dar. Im Zeitfenster sind vier Datenflanken enthalten, D0 bis D3. Die effektive Anzahl von Clockflanken ist auch vier: C0, C1, C2 und C3. C4 wird nicht verarbeitet, da ihre obere Zeitgrenze $t_F^+(4)$ außerhalb des Zeitfensters liegt.

**Die Methode A** verbindet Daten- mit Clockflanken nach der Regel

$$\text{Wenn } |D_a - C_b| \leq \Delta \text{, dann passen } D_a \text{ und } C_b \text{ zusammen. } (a,b \geq 0), \qquad (7)$$

wobei $\Delta$ so gewählt wird, damit die Zeitachse in sich nicht überlappende Intervalle aufgeteilt wird. Datenflanken, die in die von den Intervallen nicht gedeckten Bereichen fallen, werden einfach ignoriert. Gemäß Figur 6 gilt

- C0 und C3 bleiben partnerlos und werden als Flankenlücken markiert. Die Flankenlücken werden vor der Filterung im PLL-Kern mit einer Schätzung des PLL-Clocks ausgestopft, wie beispielsweise eine korrigierte Version des Front Clocks.
- C1 ist mit D0 verbunden.

- D1 und D2 kämpfen um die Clockflanke C2. Höchstens ist eine Datenflanke pro Clockflanke zugelassen, deswegen wird z.B. die Flanke mit niedrigstem Index bevorzugt - in diesem Fall D1. Das Auftreten einer Datenflankenkollision wird eventuell gemeldet.

Formell lässt sich die Flankenzuordnung in Matrixform mit folgender Tabelle beschreiben:

Tabelle 1: Zuordnungsmatrix für Methode A.

| $\lvert D_a\text{-}C_b\rvert \le \Delta$ | C0 | C1 | C2 | C3 |
|---|---|---|---|---|
| D0 | 0 | 1 | 0 | 0 |
| D1 | 0 | 0 | 1 | 0 |
| D2 | 0 | 0 | 1 | 0 |
| D3 | 0 | 0 | 0 | 0 |

Die Clock- und Datenflanken sind jeweils chronologisch sortiert. Unter der Annahme, dass pro Bitperiode höchstens eine Datenflanke entsteht, kann die Berechnung der Elemente in der unteren schattierten Dreiecksmatrix zum Senken des Rechenaufwandes übersprungen werden. Dies jedoch verringert die Robustheit der Zuordnungsmatrix für den Fall, dass mehrere Datenflanken pro Bitperiode auftreten, wie es z.B. beim Einrasten der PLL der Fall sein kann. Kompromisslösungen, wo nur die Elementen der untersten Diagonalen automatisch auf Null (0) gesetzt werden, sind denkbar.

**Die Methode B** stellt eine leichte Variation des gleichen Ansatzes dar. In diesem Fall wird die Zeitachse über die Zeitpunkte $Q_b$ in aneinanderliegende Intervalle aufgeteilt. Die $Q_b$ entsprechen den Zeitpunkten $t_F^+(k)$, welche zur Ermittlung der effektiven Clockflankenanzahl berechnet werden. Daten- und Clockflanken werden nun nach der Regel

$$\text{Wenn } Q_{b-1} < D_a \le Q_b, \text{ dann passen } D_a \text{ und } C_b \text{ zusammen } (a, b \ge 0), \qquad (8)$$

miteinander verknüpft. Daraus entsteht eine Zuordnungsmatrix wie bei Methode A - im betrachteten Beispiel stimmen beide Matrizen genau überein.

Die erkannten Flankenlücken werden gesondert behandelt. Der Phasen- bzw. Timingfehler e(k) zwischen Daten- und Clockflanken stellt die Regeldifferenz des PLL-Regelkreises dar. Bei Flankenlücken ist der Phasenfehler nicht definiert. In einer herkömmlichen Software-PLL gemäß Figur 1 wird für jede Flankenlücke den Phasenfehler e(k) =0 künstlich eingeführt. Das entspricht dem Fall, dass die lückenbehaftete Flankenfolge $x_0$(k) im Voraus mit künstlichen Flanken vervollständigt wurde, die genau mit der zurück gewonnenen Clockflanken y(k) übereinstimmen.

Die EMPU interpoliert $x_0$(k) und erzeugt eine lückenlose Datenflankenfolge x(k), welche dann vom PLL-Kern verarbeitet wird. Die Interpolation erfolgt beispielsweise durch Ausfüllen der Flankenlücken mit einer künstlichen Flanke. Um den Fall e(k) = 0 zu approximieren, nutzt man eine Prädiktion der PLL-Clockflanken wie beispielsweise den Front Clock aus. Andere Ansätze wie e(k) = e(k-1) sind durch geeignete Wahl der interpolierenden Flanken realisierbar. Obwohl das Ausfüllen zu Erläuterungszwecken in der EMPU stattfindet, kann dies implementierungsabhängig an einer oder mehreren Stellen im Verarbeitungspfad zwischen Flankenlückenzuordnung und PLL-Kern realisiert sein.

ZEITDARSTELLUNG

In der Praxis werden alle Zeitpunkten, unter anderem die Daten- und Clockflanken, mit einer endlichen Bitwortbreite ausgedrückt. Die Verwendung einer absoluten Zeitreferenz ist für Systeme, die für lange Zeitabschnitte im Betrieb sind, ungeeignet. In diesem Zusammenhang ist die Verarbeitung relativer Zeitangaben vorteilhaft. Dies kann unter anderem auf zwei miteinander kombinierbaren Weisen erfolgen:

- Periodisches und synchronisiertes Rücksetzten der Zeitreferenz der Datenflanken und der Clockflanken. Damit lassen sich beispielweise die Daten- und Clockflanken als ein Offset zum Beginn des aktuellen Systemtaktes ausdrücken.
- Stauchung der Zeit durch Anwendung eines Normalisierungsfaktors. Das ist insbesondere für die Verarbeitung von Datenströmen mit einer Bitperiode größer als einem Systemtakt geeignet.

GESAMTSYSTEMÜBERBLICK

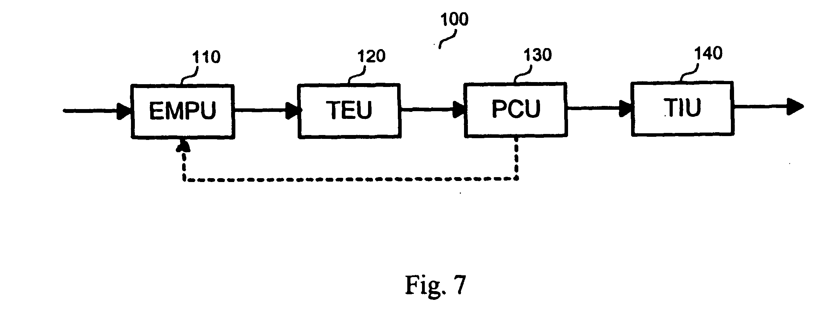

**Figur 7** zeigt einen Überblick über ein Gesamtsystem zur Taktrückgewinnung gemäß der Erfindung.

Es wird angenommen, dass die Datenflanken in einem geeigneten Format bereitgestellt werden. Beispielsweise wird die Zeitachse bei niedrigen Bitraten (d.h. großen Bitperioden) zusätzlich normiert, damit die Flankenzeitpunkte mit einer begrenzten Wortbreite darstellbar sind.

Das System umfasst zunächst eine Edge Matching and Patching Unit (EMPU) 110. Hier findet die Zuweisung zwischen Daten- und Clockflanken statt. Ein internes Clocksignal, Front Clock genannt, gibt die Lage der Clockflanken approximativ an. Auf dieser Grundlage werden die Flankenlücken erkannt und als solche markiert. Die Flankenlücken werden beispielsweise hier aber grundsätzlich vor dem Block PCU 130 auf geeignete Weise interpoliert, um eine lückenlose Datenflankenfolge zu erhalten. Die Datenflanken werden sortiert und unverändert weitergegeben.

Des Weiteren umfasst das System eine Trend Extraction Unit (TEU) 120. Aus den Datenflanken wird ein linearer Trend abgezogen. Der lineare Trend ist durch das so genannte Nominal Clock gegeben, welches ausschließlich mit der nominalen Bitperiode getrieben wird. Der Ausgang der TEU besteht aus den Datenflankenpositionen bezüglich des Nominal Clocks.

Ferner enthält das System eine PLL Core Unit (PCU) 130. Die PCU beinhaltet den PLL-Kern, der parallel eine Vielzahl von Datenflanken verarbeitet. Der PLL-Kern ist gemäß der Erfindung als lineares Filter bzw. lineare Differenzengleichung darstellbar.

Aufgrund der Latenz der Verarbeitungskette verwendet man zwei Clocksignale, einerseits den Front Clock in der EMPU zur Zuordnung von Daten- und Clockflanken und andererseits das von der PCU gelieferten PLL-Clock, welcher für die Berechnung der Phasenfehler im Sinne von e(k) in Figur 1 zuständig ist. Die PCU schätzt aus dem PLL-Clock die Bitperiodenabweichung bezüglich der nominalen Bitperiode. Mit Information aus der PCU ermittelt die EMPU den Front Clock, welcher im Grunde eine Prädiktion der PCU-Clockflanken zum Überbrücken der Verarbeitungslatenz darstellt.

Schließlich umfasst das System eine Trend Injection Unit (TIU) 140. Hier wird den Clockflanken aus der PCU der Nominal Clock hinzugefügt, um die endgültige Clockflankenlage zu erhalten. Wie in der TEU 120 beschreibt der Nominal Clock einen linearen Trend.

Die PCU 140 ist in der Lage, eine Vielzahl von Datenflanken durch eine geeignete Implementierung der linearen Differenzengleichung aus Gleichung (5) parallel zu verarbeiten. Im Online-Betrieb, in dem das Datensignal ständig beobachtet wird, kann die Anzahl von Datenflanken pro Zeiteinheit leicht schwanken. Beispielsweise kommt bei einem Datenstrom mit einer durchschnittlichen Bitperiodenanzahl von 2,5 pro Systemtakt vor, dass abwechselnd 3 und 2 Flanken parallel verarbeitet werden. Der Entwurf der PCU wird vereinfacht, wenn der PLL-Kern mit einer konstanten Parallelität angesteuert wird.

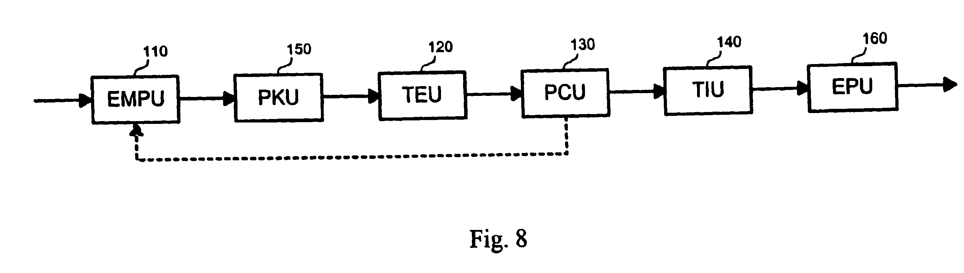

In Bezug darauf zeigt **Figur 8** eine weitere Ausführungsform der Erfindung. Grundsätzlich vor der PCU und beispielsweise unmittelbar nach der EMPU sammelt die Packetizer Unit (PKU) 150 die ankommenden Datenflanken auf und gibt sie in Paketen fester Größe aus. Durch die Paketisierung entstehen Durchsatzschwankungen, denn die PKU muss gelegentlich einen Wartezyklus zum Sammeln einer genügenden Anzahl von Datenflanken einführen und leitet in diesem Fall ein leeres Datenflankenpaket an den nächsten Funktionsblock weiter. Diese Durchsatzschwankungen werden in der Edge Publishing Unit (EPU) 160 kompensiert. Die Clockflanken-Pakete werden aufgelöst und die Clockflanken mit der Systemzeit synchronisiert.

In einer anderen Ausführungsform der PCU kann die parallele Realisierung der Differenzengleichung (5) umgangen werden, indem zunächst die Datenflanken nach geeigneter Tiefpassfilterung dezimiert werden, der resultierende Datenflankenstrom anschließend mit einem PLL-Kern niedriger oder sogar einfacher Parallelität verarbeitet wird und schließlich die zurück gewonnenen, dezimierten Clockflanken über einen Interpolationsschritt auf die ursprüngliche Parallelität zurückgeführt werden. Beispielsweise kann die Dezimation durch Mittelwertbildung über die Elemente in einem Datenflankenpaket erfolgen. Die Clockflanken lassen sich exemplarisch durch lineare Interpolation der dezimierten Clockflankenfolge zurückgewinnen.

Die Erfindung ist nicht auf das dargestellte Ausführungsbeispiel beschränkt

**Patentansprüche**

**1.** Verfahren zur Rückgewinnung eines Taktsignals aus einem Datensignal, wobei die Flanken des Taksignals und des Datensignals jeweils als chronologisch geordnete Sequenz von Zeitpunkten repräsentiert sind, **dadurch gekennzeichnet, dass** in einem Verarbeitungsschritt eine Vielzahl von Zeitpunkten des Datensignals wie folgt parallel verarbeitet wird:

- Bereinigung der Zeitpunkte des Datensignals mittels Abziehen eines auf einer nominalen Bitperiode basierenden nominalen Takts von den Datenflanken;
- Schätzen einer Bitperiodenabweichung bezüglich der nominalen Bitperiode; und
- Hinzufügen des nominalen Takts zu den geschätzten Bitperiodenabweichungen.

**2.** Verfahren nach Anspruch 1, wobei die Bitperiodenabweichungen für die bereinigten Zeitpunkte mittels eines parallelen Filters geschätzt werden.

**3.** Verfahren nach Anspruch 2, ferner umfassend den Schritt:

- Zuordnen der Datenflanken des Signals zu Takt und Interpolation von erkannten Flankenlücken.

**4.** Verfahren nach Anspruch 3, wobei die Zuweisung von Datenflanken zu Taktflanken ein eigenes Taktsignal (FRONT CLOCK) verwendet, welches mit dem Taktsignal des parallelen linearen Filters phasengekoppelt ist.

**5.** Verfahren nach Anspruch 4, wobei eine Datenflanke $D_a$ einer Taktflanke $C_b$ zugeordnet wird, wenn gilt

$$\left| D_a - C_b \right| \leq \Delta \quad a, b \geq 0,$$

wobei $\Delta$ so gewählt wird, dass die Zeitachse in sich nicht überlappende Intervalle aufteilt wird.

**6.** Verfahren nach Anspruch 4, wobei eine Datenflanke $D_a$ einer Taktflanke $C_b$ zugeordnet wird, wenn gilt

$$Q_{b-1} < D_a \leq Q_b \quad a, b \geq 0,$$

wobei die Zeitpunkte $Q_b$ die Zeitachse in aneinanderliegende Intervalle aufteilen.

**7.** Verfahren nach Anspruch 4, wobei Phasenabweichungen des eigenen Taktsignal (FRONT CLOCK) und des Taktsignals des parallelen linearen Filters kumuliert und erst nach Überschreiten einer vorbestimmten Schwelle für das eigene Taktsignal (FRONT CLOCK) übernommen werden.

**8.** Verfahren nach Anspruch 2, wobei das parallele lineare Filter nach dem Clustered Look-Ahead-Prinzip arbeitet.

**9.** Verfahren nach Anspruch 2, wobei das parallele lineare Filter nach dem Scattered Look-Ahead-Prinzip arbeitet.

**10.** Maschinell lesbarer Datenträger, der Instruktionen speichert, welche, ausgeführt durch einen Computer, ein Verfahren nach einem der vorhergehenden Ansprüche durchführen.

**11.** Vorrichtung zur Rückgewinnung eines Taktsignals aus einem Datensignal, wobei die Flanken des Taktsignals und des Datensignals jeweils als chronologisch geordnete Sequenzen von Zeitpunkten repräsentiert sind, umfassend:

- Mittel zur Bereinigung des Datensignals mittels Abziehen eines auf der nominalen Bitperiode basierenden nominalen Takts von den Datenflanken;
- Mittel zum Schätzen einer Bitperiodenabweichung bezüglich der nominalen Bitperiode; und
- Mittel zum Hinzufügen des nominalen Takts zu den geschätzten Bitperiodenabweichungen,
**dadurch gekennzeichnet, dass** die Mittel derart angeordnet und miteinander verbunden sind, dass in einem Verarbeitungsschritt eine Vielzahl von Zeitpunkten des Datensignals parallel verarbeitet werden kann.

**12.** Vorrichtung nach Anspruch 11, wobei das Mittel zum Schätzen der Bitperiodenabweichungen für die bereinigten Zeitpunkte ein paralleles lineares Filter ist.

**Claims**

**1.** Method for the recovery of a clock signal from a data signal, wherein the edges of the clock signal and the data signal are each represented as a chronologically-ordered sequence of timing points, **characterised in that,**
in one procedural stage, a plurality of timing points of the data signal is processed in parallel as follows:

- adjustment of the timing points of the data signal by subtracting a nominal clock pulse based on a nominal bit period from the data edges;
- estimation of a bit-period deviation with reference to the nominal bit period; and
- addition of the nominal clock pulse to the estimated bit-period deviations.

2. Method according to claim 1,
wherein the bit-period deviations for the adjusted timing points are estimated by means of a parallel filter.

3. Method according to claim 2, further comprising the stage:

- assignment of the data edges of the signal to the clock pulse and interpolation of identified missing edges.

4. Method according to claim 3, wherein the assignment of data edges to clock edges uses an internal clock signal (FRONT CLOCK), which is phase-coupled with the clock signal of the parallel linear filter.

5. Method according to claim 4, wherein a data edge $D_a$ is assigned to a clock edge $C_b$, if the following applies:

$$\left| D_a - C_b \right| \leq \Delta \quad a, b \geq 0 \,,$$

wherein $\Delta$ is selected in such a manner that the time axis is subdivided into mutually nonoverlapping intervals.

6. Method according to claim 4, wherein a data edge $D_a$ is assigned to a clock edge $C_b$, if the following applies:

$$Q_{b-1} < D_a \leq Q_b \quad a, b \geq 0 \,,$$

wherein the timing points $Q_b$ subdivide the time axis into mutually-adjacent intervals.

7. Method according to claim 4, wherein phase deviations of the internal clock signal (FRONT CLOCK) and of the clock signal of the parallel linear filter are accumulated and adopted only after a predetermined threshold for the internal clock signal (FRONT CLOCK) has been exceeded.

8. Method according to claim 2, wherein the parallel linear filter operates according to the clustered look-ahead principle.

9. Method according to claim 2, wherein the parallel linear filter operates according to the scattered look-ahead principle.

10. Machine-readable data medium, which stores instructions, which implement a method according to any one of the preceding claims when executed by a computer.

11. Device for the recovery of a clock signal from a data signal, wherein the edges of the clock signal and the data signal are each represented as chronologically-ordered sequences of timing points, comprising:

- means for adjusting the data signal by subtracting a nominal clock pulse based on the nominal bit period from the data edges;
- means for estimating a bit-period deviation with reference to the nominal bit period; and
- means for the addition of the nominal clock pulse to the estimated bit-period deviations, **characterised in that** the means are arranged and connected to one another in such a manner that, in one procedural stage, a plurality of timing points of the data signal can be processed in parallel.

12. Device according to claim 11, wherein the means for estimating the bit-period deviations for the adjusted timing points is a parallel linear filter.

**Revendications**

1.  Procédé de récupération d'un signal d'horloge à partir d'un signal de données, dans lequel les flancs du signal d'horloge et du signal de données sont représentés respectivement sous la forme d'une séquence de moments ordonnée chronologiquement, **caractérisé en ce que**, lors d'une étape de traitement, une pluralité de moments du signal de données est traitée parallèlement comme suit :

    nettoyage des moments du signal de données par le retrait d'une horloge nominale basée sur une période de bits nominale des flancs de données ;
    estimation d'un écart de la période de bits par rapport à la période de bits nominale ; et
    ajout de l'horloge nominale aux écarts de période de bits estimés.

2.  Procédé selon la revendication 1, dans lequel les écarts de période de bits pour les moments nettoyés sont estimés au moyen d'un filtre parallèle.

3.  Procédé selon la revendication 2, comportant en outre l'étape consistant à :

    affectation des flancs de données du signal à une horloge et interpolation des manques de flancs reconnus.

4.  Procédé selon la revendication 3, dans lequel l'affectation des flancs de données au flanc d'horloge utilise un signal d'horloge propre (FRONT CLOCK), qui est couplé en phase avec le signal d'horloge du filtre linéaire parallèle.

5.  Procédé selon la revendication 4, dans lequel un flanc de données $D_a$ est associé à un flanc d'horloge $C_b$, si

$$|D_a - C_b| \leq \Delta \qquad a,b \geq 0,$$

    où $\Delta$ est choisi de sorte que l'axe des temps est divisé en intervalles ne se chevauchant pas.

6.  Procédé selon la revendication 4, dans lequel un flanc de données $D_a$ est associé à flanc d'horloge $C_b$, si

$$Q_{b-1} < D_a \leq Q_b \qquad a,b \geq 0$$

    où les moments $Q_b$ divisent l'axe des temps en intervalles se chevauchant.

7.  Procédé selon la revendication 4, dans lequel des écarts de phase du signal d'horloge propre (FRONT CLOCK) et du signal d'horloge du filtre linéaire parallèle s'ajoutent et sont considérés comme signal d'horloge propre (FRONT CLOCK) après le dépassement d'un seuil prédéfini.

8.  Procédé selon la revendication 2, dans lequel le filtre linéaire parallèle fonctionne selon le principe Clustered Look-Ahead.

9.  Procédé selon la revendication 2, dans lequel le filtre linéaire parallèle fonctionne selon le principe Scattered Look Ahead.

10.  Support de données pouvant être lu par un ordinateur, qui comporte des instructions, qui, lorsqu'il est exécuté par un ordinateur, exécutent un procédé selon l'une des revendications précédentes.

11.  Dispositif de récupération d'un signal d'horloge à partir d'un signal de données, dans lequel les flancs du signal d'horloge et du signal de données sont représentés respectivement sous la forme de séquences de moments ordonnées chronologiquement, comportant :

    un moyen pour nettoyer le signal de données grâce à une horloge nominale basée sur la période de bits nominale des flancs de données ;
    un moyen pour estimer un écart de période de bits par rapport à la période de bits nominale ; et

un moyen pour ajouter l'horloge nominale aux écarts de période de bits estimés,

**caractérisé en ce que** les moyens sont disposés et associés de sorte que, lors d'une étape de traitement, une pluralité de moments du signal de données peut être traitée parallèlement.

12. Dispositif selon la revendication 11, dans lequel le moyen pour estimer les écarts de période de bits pour les moments nettoyés est un filtre linéaire parallèle.

Fig. 1

Fig. 2

EP 2 215 766 B1

Clockflanke

Datenflanke

$T_b/2$   $T_b/2$

k-1        k          k+1        k+2

t

Zeit

Fig. 3

Fig. 4

Front Clock

PLL-Clockflanken

Datenflanke

Phasenoffset

k-1

k

k+1

k+2

t

Fig. 5

Fig. 6

EP 2 215 766 B1

Fig. 7

Fig. 8

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- EP 0912010 A1

### In der Beschreibung aufgeführte Nicht-Patentliteratur

- **K. Parhi ; D. Messerschmitt.** Pipeline Interleaving and Parallelism in Recursive Digital Filters - Part I: Pipelining Using Scattered Look-Ahead and Decomposition'' und ''Pipeline Interleaving and Parallelism in Recursive Digital Filters - Part II: Pipelined Incremental Block Filtering. *IEEE Transactions on Acoustics, Speech and Signal Processing,* Juli 1989, vol. 37 (7), 1099-11171118-1134